(19) Europäisches Patentamt

European Patent Office

Office européen des brevets

(11) **EP 1 638 282 A1**

(12) **EUROPEAN PATENT APPLICATION**

(43) Date of publication:
**22.03.2006 Bulletin 2006/12**

(51) Int Cl.:
**H04L 27/00** *(2006.01)* **H04B 1/58** *(2006.01)*

(21) Application number: **04077552.0**

(22) Date of filing: **15.09.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **STMicroelectronics Belgium N.V.**
**1930 Zaventem (BE)**

(72) Inventor: **Latte, Olivier Rene Nicolas**
**1020 Brussels (BE)**

(74) Representative: **Bird, Ariane et al**
**Bird Goën & Co**
**Klein Dalenstraat 42A**
**3020 Winksele (BE)**

(54) **Line driver with output impedance synthesis for DSL transceivers**

(57)     A line driver circuit (250) couples a data transceiver (210,220) to a line (230). The line driver (250) comprises a differential amplifier (OA1,OA2) which receives a signal for transmission on the line. First and second feedback paths (Z1) connect between outputs of the amplifier and inputs of the amplifier. A bridge (260) couples the differential amplifier (OA1,OA2) to the line (230). The bridge comprises two matching impedance and two secondary transformer winding. Each matching impedance is connected in series with a secondary transformer winding between the outputs of the amplifiers. Two feedback branches connect between tap-points part-way along the secondary windings (262 and 261) and the inputs of the differential amplifier. The line driver circuit (250) shows low sensitivity to accuracy of component values while providing an increased dynamic on the line for a given dynamic of the transceiver and a given attenuation of the received signal.

Fig. 7

EP 1 638 282 A1

Description

FIELD OF THE INVENTION

This invention relates to a line driver for coupling a data transceiver to a line which is particularly useful for, but not limited to, coupling a broadband modem to a transmission line as well as to stationary or portable devices having such a modem, to methods of operating a line driver and producing signals, and methods of offering a communication service over a link having such a modem.

BACKGROUND TO THE INVENTION

Digital Subscriber Line (DSL) transmission systems have become very popular throughout the world for the transmission of data. The high bit rate versus distance characteristic of DSL systems make them convenient systems to provide households and small companies with services such as broadband internet access, video distribution and voice communications.

DSL standards generally use a Discrete MultiTone (DMT) transmission scheme to deliver data over a twisted pair transmission line. The DMT signal is obtained by summing a large number of carriers of relatively small power, each carrier being individually modulated in amplitude and phase. The resulting DMT signal is characterized by a very large peak-to-average ratio (PAR). Both the transmitter and the receiver of a modem have to handle these large peaks. If the signal is clipped by the transmitter or receiver, noise is added to the signal which is spread over a wide frequency band and generally has the effect of inducing errors in the data.

The impedance presented by a modem to the line should be substantially equal to the characteristic impedance of the line in order to obtain good return loss figures. This impedance is obtained by placing a passive impedance between the output of the transceiver and the load. Because of the line matching, some part of the power delivered by the transceiver is dissipated in the circuitry that couples the transceiver to the line. Because of the large PAR of the DMT signal, the voltage of the transceiver supply must be much larger than the RMS voltage delivered by the transceiver to its load. Both those requirements make transceivers used in DSL systems quite inefficient.

A concept called Active Back Termination (ABT) or Impedance Synthesis is commonly used to reduce the amount of power dissipated in the circuit coupling the transceiver to the line and to reduce the voltage of the transceiver supply. This concept feeds information about the voltage and/or current flowing through the transceiver's load back to the transceiver's input. This information is used to adjust the voltage at the output of the transceiver so that the impedance seen from the load is higher than the passive impedance placed between the transceiver and the load.

European Patent Application EP 0 901 221 A1 shows a circuit of this kind which makes use of a feedback signal that is proportional to the current flowing through the load and inversely proportional to the difference between two resistors, i.e. the synthesized impedance increases when the difference between the resistors decreases. There is a passive impedance in the form of a resistor in series with the amplifier and the synthesized impedance is the passive impedance multiplied by a synthesis factor >1. The accuracy of the synthesized output impedance decreases as the difference between two resistors decreases, for a given accuracy of the resistors.

There are two limitations on reducing the passive impedance in series with the line. A first limitation is that the degree of reduction is limited by the accuracy of the resistors used for the implementation. The accuracy of the synthesized impedance is particularly dependent on the accuracy of the resistors at low values of the passive output impedance (high values of the synthesis factor). A second limitation is due to the need to couple a receiver to the line. Modems are coupled to the line by a hybrid circuit that allows both the transmitter and the receiver of the modem to respectively transmit and receive signals on the line in the same frequency range. The hybrid circuit is designed so that a minimum amount of the transmit signal is captured by the receive path. The ideal echo cancellation translates into constraints that induce attenuation in the receive path and the attenuation increases as the passive output impedance is reduced. The received signal should not be attenuated too greatly to avoid performance degradations due to the noise floor of the receive path.

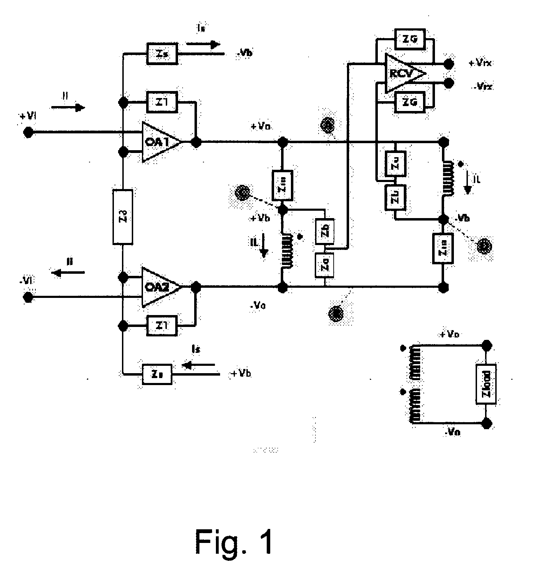

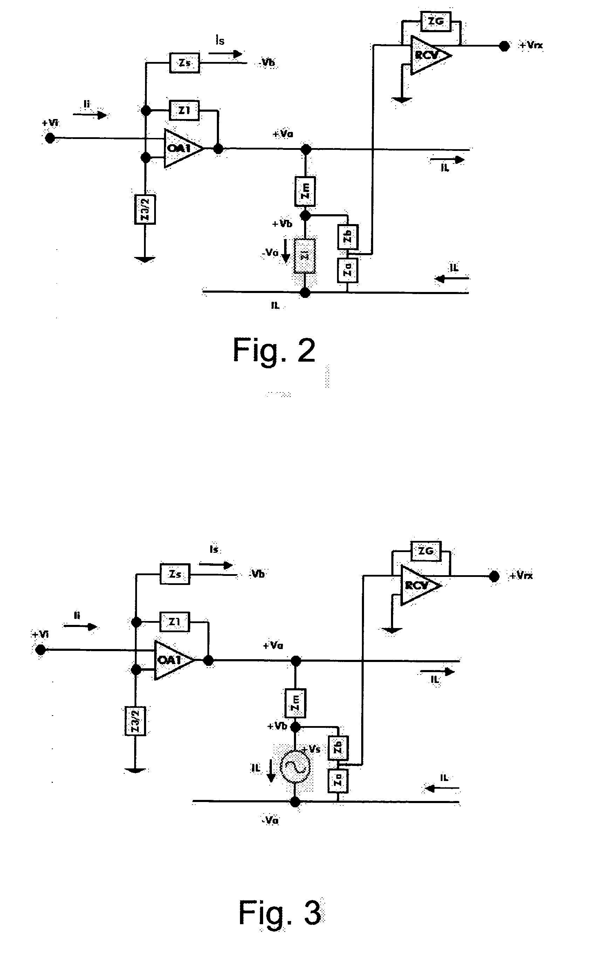

There have been several proposals to reduce the impact of the above limitations. European Patent Application EP 1 241 799 proposes a circuit which, by its topology, allows for a higher dynamic voltage on the line for a given dynamic voltage on the line driver. This circuit is shown in Figures 1 to 3. As a result, for a given requirement of dynamic voltage on the line and on the output of the line driver, the required turns ratio of the coupling transformer is lower than in the circuit of EP 0 901 221. As a result of this lower turns ratio, the circuit induces less attenuation of the receive signal. Nevertheless, this circuit still suffers from the first limitation described above.

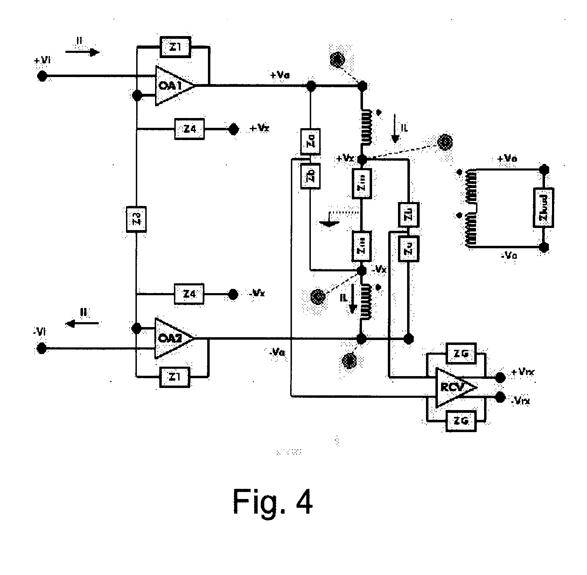

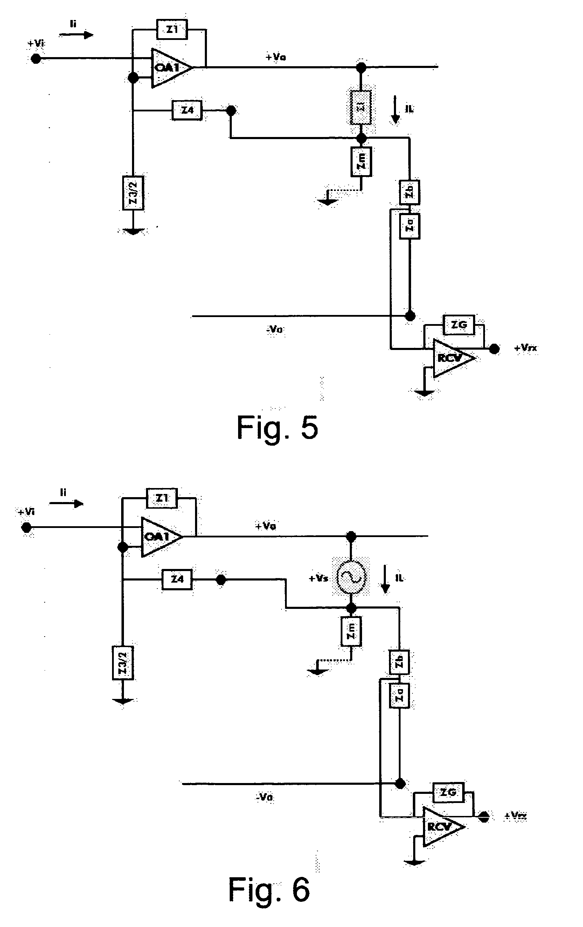

US Patent Application US 2002/0118732 A1 proposes an architecture which does not suffer from the first limitation described above. This is shown in Figures 4 to 6. The synthesized impedance does not depend on a difference of resistors. A higher degree of reduction in the passive impedance can be achieved for a given accuracy of the synthesized impedance and a given accuracy of the components implementing the circuit. On the other hand, the attenuation of the received signal, for a given voltage dynamic of the transceiver and on the line, is double that of the circuit described in EP 1 241 799.

The present invention seeks to reduce the power consumption of a transmitter and the level of the voltage supply required to put a given power on the line while featuring a low attenuation of the receive signal.

**SUMMARY OF THE INVENTION**

A first aspect of the present invention provides a line driver circuit for coupling a data transceiver to a line, other aspects of the invention include a bridge for use in the line driver circuit, a corresponding method of operating the line driver circuit, a method of offering a communication service over a link having a modem or line driver as set out above as well as a communications system including such modems and line drivers.

The line driver can comprise:

a first amplifier having a pair of inputs and an output;
a second amplifier having a pair of inputs and an output, the first and second amplifiers forming a differential amplifier which can receive a signal (+Vi, -Vi) for transmission on the line;
a first feedback path connected between an output of the first amplifier and an inverting input of the first amplifier;
a second feedback path connected between an output of the second amplifier and an inverting input of the second amplifier;
a bridge coupling the first and second amplifiers to the line, the bridge comprising:

a first matching impedance (Zm) and a first secondary transformer winding connected in series between the outputs of the amplifiers;
a second matching impedance (Zm) and a second secondary transformer winding connected in series between the outputs of the amplifiers, the first and second secondary windings being magnetically coupled to at least one primary winding which is connected to the line;
a third feedback path connected between an internal node (-Vx) of the first secondary winding and an inverting input of the first amplifier; and,
a fourth feedback path connected between an internal node (+Vx) of the second secondary winding and an inverting input of the second amplifier.

This line driver circuit provides an advantage of a synthesized impedance whose accuracy does not decrease as the value of the synthesized impedance increases. It also provides an advantage of maximizing the received signal, while satisfying the constraint of improved, ideally best possible echo cancellation (i.e. no transmit signal on the receive nodes. This second advantage is linked with a minimized dynamic at the output of the amplifier for a given dynamic at the input of the line and this is obtained by connecting the load and the matching impedance between both outputs of the differential amplifier.

Information about current through the load is obtained by sensing the voltage, and hence current, of the load on an internal node of the secondary winding rather than on one of two external nodes of the load or on an impedance placed in series with the load.

In the line driver, each of the first and second feedback paths can include an impedance Z1 and each of the third and fourth feedback paths can include an impedance Z4 and the circuit can be operable to provide an impedance synthesis ratio (ISR) which is defined by the expression:

$$ISR = \frac{Z1 + Z4}{Z4}.$$

The line driver circuit can also comprise:

a first impedance divider (Za, Zb) which is placed in parallel with the first secondary winding and having an output for connecting to a receive stage;
a second impedance divider which is placed in parallel with the second secondary winding and having an output for connecting to the receive stage.

The line driver circuit can have a dynamic gain defined by the expression:

$$2 \bullet n \bullet \frac{ISR}{1 + ISR}$$

where n is the turns ratio of the secondary and primary windings and *ISR* is the impedance synthesis ratio.

The branches of the bridge containing the matching impedances (Zm) can have an impedance which is significantly smaller than the equivalent impedances of the other branches of the bridge. At least one of the matching impedances (Zm), the impedance divider (Za, Zb) or impedances used in the feedback paths (Z1, Z4) can be variable.

The first feedback path and the second feedback path can be connected between an output and a non-inverting input of a respective amplifier or the first feedback path and the second feedback path can be connected between an output and an inverting input of a respective amplifier.

In a further aspect of the present invention bridge is provided for forming part of a line driver circuit for coupling a data transceiver to a line, the bridge comprising:

   four legs connected between nodes A, B, C, D;
   nodes A and B are connectable to outputs of a differential amplifier in the line driver circuit;
   a first matching impedance (Zm) connected between nodes A and C and a second matching impedance (Zm) connected between nodes B and D;
   a first secondary transformer winding connected between nodes C and B and a second secondary transformer winding connected between nodes A and D, the first and second secondary windings being magnetically coupled to at least one primary winding which is connected to the line;
   a first tap point connected to an internal node (+Vx) of the first secondary winding a second tap point connected to an internal node (-Vx) of the second secondary winding, the first and second tap points forming feedback paths for connecting to the differential amplifier. The bridge can also include a first impedance divider (Za, Zb) connected between nodes C and B and having an output for connecting to a receive stage;
   a second impedance divider (Za, Zb) connected between nodes D and A and having an output for connecting to the receive stage.

In yet a further aspect of the present invention a modem is provided comprising a line driver circuit or a bridge as defined above.

The present invention also provides a portable or stationary device incorporating a line driver circuit, a bridge or a modem as defined above.

The present invention also provides a communications system incorporating the any apparatus described above.

In another aspect, the present invention provides a method of operating a line driver circuit which couples a data transceiver to a line comprising:

   applying a signal (+Vi, -Vi) for transmission on the line to inputs of a first amplifier and a second amplifier;
   providing a first feedback path between an output of the first amplifier and an input of the first amplifier;
   providing a second feedback path between an output of the second amplifier and an input of the second amplifier;
   coupling the first and second amplifiers to the line by a bridge which comprises a first matching impedance (Zm) and a first secondary transformer winding connected in series between the outputs of the amplifiers and a second matching impedance (Zm) and a second secondary transformer winding connected in series between the outputs of the amplifiers, the first and second secondary windings being magnetically coupled to at least one primary winding which is connected to the line;
   providing a third feedback path between an internal node (-Vx) of the first secondary winding and an inverting input of the first amplifier; and,
   providing a fourth feedback path connected between an internal node (+Vx) of the second secondary winding and an inverting input of the second amplifier (OA2).

The method can include providing a first impedance divider (Za, Zb) in parallel with the first secondary winding and a second impedance divider which is placed in parallel with the second secondary winding and taking an output, for applying to a receive stage, from the first and second impedance dividers.

In another aspect the present invention provides a method of producing a signal for transmission on a line or receiving a signal on a line using the above method.

## BRIEF DESCRIPTION OF THE DRAWINGS

Embodiments of the invention will be described with reference to the accompanying drawings in which:

Figure 1 shows a known line driver circuit as described in EP 1 241 799;

Figure 2 shows a simplified version of the line driver circuit of Figure 1 to find the characteristics of the circuit when transmitting;

Figure 3 shows a simplified version of the line driver circuit of Figure 1 to find the characteristics of the circuit when receiving;

Figure 4 shows another known line driver circuit as described in US 2002/0 118 732 A1;

Figure 5 shows a simplified version of the line driver circuit of Figure 4 to find the characteristics of the circuit when transmitting;

Figure 6 shows a simplified version of the line driver circuit of Figure 4 to find the characteristics of the circuit when receiving;

Figure 7 schematically shows a line driver circuit according to an embodiment of the present invention;

Figure 8 shows a simplified version of the line driver circuit of Figure 7 to find the characteristics of the circuit when transmitting;

Figure 9 shows a simplified version of the line driver circuit of Figure 7 to find the characteristics of the circuit when receiving; and,

Figures 10 and 11 show the performance of the line driver circuit according to the present invention compared to the performances of prior art circuits.

## DESCRIPTION OF PREFERRED EMBODIMENTS

The present invention will now be described with reference to certain embodiments and with reference to the above mentioned drawings. Such description is by way of example only and the invention is not limited thereto.

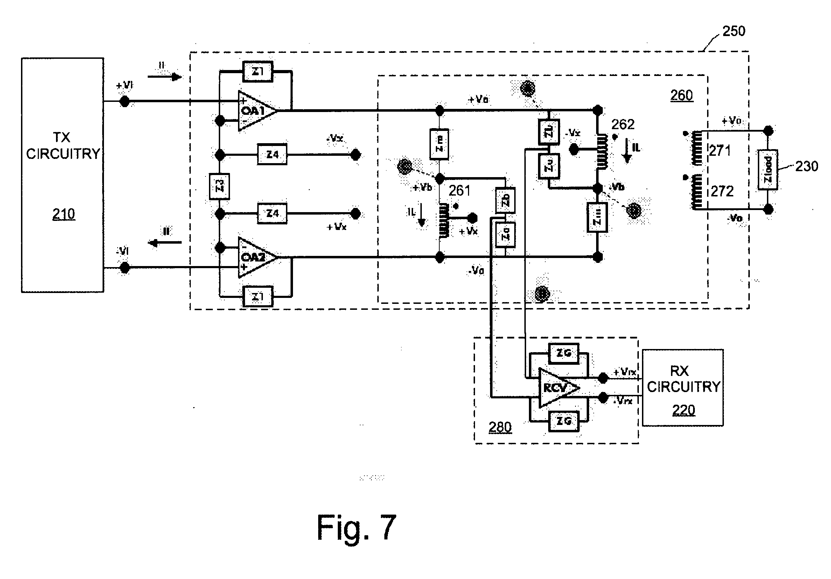

Figure 7 shows a line driver circuit 250 which is suitable for use in connecting a transmitter 210 and/or a receiver 220 of a data transceiver, such as a broadband modem, to a transmission line 230 (represented by a load Z), such as a twisted pair line. The modem can operate according to one of the family of Digital Subscriber Line (so-called xDSL) technologies such as Asymmetric Digital Subscriber Line (ADSL). The line driver circuit 250 comprises a differential amplifier which may be formed from two operational amplifiers OA1, OA2, for example. A signal which is to be transmitted +Vi, -Vi is applied to a non-inverting input of each amplifier OA1, OA2.

There are two sets of feedback paths around the amplifiers OA1, OA2. One set of feedback paths relates mainly to the gain. They can be implemented so as to obtain an inverting or non-inverting topology. The second set of feedback paths relates to the impedance synthesis.

The first feedback paths each connect between an output of the amplifier and an inverting input of the amplifier. Each path includes an impedance Z1. The feedback paths for impedance synthesis are each connected between an internal point (+Vx, -Vx) of the secondary windings 261, 262 and an inverting input of each of the operational amplifiers OA1, OA2. Each feedback path includes an impedance Z4.

The line driver circuit 250 includes a bridge 260 (also known as a hybrid circuit) with four nodes shown as A, B, C, D. Node A is taken as the output of amplifier OA1 and node B is taken as the output of amplifier OA2. The set of nodes are connected by four legs. The bridge 260 is magnetically coupled to the line by an isolation transformer having primary windings 271, 272 on the side of the transmission line and secondary windings 261, 262 on the side of the line driver circuit 250.

A transmission line is represented by its equivalent impedance Zload 230. A first leg of the bridge 260 is connected between the output of amplifier OA1 (node A) and node C and includes a matching impedance Zm. A second leg is connected between node C and the output of amplifier OA2 (node B). This second leg includes a first secondary winding 261 of the isolation transformer. A third leg of the bridge is connected between the output of amplifier OA2 (node B) and node D. The third leg includes another matching impedance Zm. A fourth leg of the bridge is connected between node D and the output of amplifier OA1 (node A). This fourth leg includes another secondary winding 262 of the isolation transformer. The matching networks will typically be made of networks of passive components like resistors, capacitors, inductors. The complex impedance of those networks aim at matching the complex impedance of the line seen through the line transformer.

The primary windings 271, 272 of the isolation transformer are connected in series and are coupled to the line ($Z_{load}$ 230). Each secondary winding 261, 262 of the isolation transformer has three nodes. Two nodes are connected to the nodes of the bridge and are called 'external' nodes while the third node is called an 'internal' node as it is connected to a tap point part-way along the winding. Each tap point forms part of a feedback loop described above. The internal node on a winding is a node which is used for probing a voltage. It can be neglected when considering the current/voltage equations of this winding. It is connected to circuitry which will sink a current much lower than the current flowing through the winding. That means that it will be connected to a circuitry of which the impedance is much higher than the equivalent impedance of the winding. An internal node does not have to be located in the middle of the winding, as illustrated. It can be placed anywhere including at the end of several turns that exceed the place where the external nodes are located.

Referring again to the bridge 260, the features of the bridge which are relevant to the receive operation will now be described. A first impedance divider is connected between nodes C and B of the bridge and comprises the impedances Za and Zb. A first input to a receive stage 280 is taken from the point between Za and Zb. A second impedance divider is connected between nodes D and A of the bridge and also comprises the impedances Za and Zb. A second input to the receive stage 280 is taken from the point between Za and Zb. The receive stage 280 comprises an amplifier RCV with feedback loops including impedances ZG which determine the gain of the amplifier. The resulting output signals +Vrx, -Vrx are applied to receive circuitry for further processing in a known manner.

The advantages of the circuits will now be described from a physical point of view. They will be discussed more in details using mathematical equations further in the text.

The impedance synthesis functionality relies on the fact that the current flowing through the impedance synthesis related feedback loop flows also through the gain related feedback loop. With a circuit according to the present invention, the feedback loop for impedance synthesis connects to a node of which the voltage swing decreases when the impedance synthesis ratio increases. This node (tap point) is a point part-way along the windings 261, 262, such as a point halfway between -Va and Vb. When the impedance synthesis ratio becomes high, -Va and Vb make swings almost equal in amplitude and opposite in phase. The tap point half-way between -Va and Vb makes swings of very small amplitude. In the impedance synthesis related loop, the current is due to a relatively low voltage applied on a relatively low impedance. In the gain related feedback loop, the same current is due to a relatively high voltage applied across a relatively high impedance. The impedance synthesis ratio is almost proportional to the ratio of the impedance of the two feedback loops. The accuracy of the ratio is the same as the accuracy of the impedances. This explains the first advantage of the circuit of this invention.

The dynamic gain of the line driving circuit is defined as the ratio of the differential voltage swing on the load (the line in this case) divided by the differential voltage swing at the output of the differential amplifier (in this case made of two single-ended amplifiers) when a transmit signal is present but no receive signal is present. Referring to the circuit shown in fig.7, the dynamic gain is Vd(Zload) /Vd(amplifier) = (Vo-(-Vo)) / (Va-(-Va)) = Vo / Va. The maximum voltage swing at the ouput of the amplifier is defined by the voltage supply of this latter. The required maximum voltage swing on the line will be defined by the application. One may deduce a requirement of dynamic gain based on those two constraints. The dynamic gain will depend on the line driver topology and is proportional to the transformer turns ratio.

The receive gain of the hybrid circuit is defined as the ratio of the differential voltage swing on the receive circuit divided by the differential voltage swing on the line when a receive signal is present but no transmit signal is present. Referring to the circuit shown in fig.7, the receive gain is (Vrx-(-Vrx)) / (Vo-(-Vo)) = Vrx / Vo. The required minimum receive gain will be defined by the application and by the noise floor at the input of the receive circuit. The receive gain will depend on the transformer turns ratio. The receive gain depends on the line driver and hybrid circuit topology and is inversely proportional to the transformer turns ratio

Thanks to the connection of the load in series with a passive impedance between both outputs of a differential amplifier, the circuit of this invention has a high dynamic gain linked with the circuit topology. For a given total dynamic gain constraint, a relatively low transformer turns ratio can be used leading to a relatively low attenuation of the receive signal. This explains the second advantage of the circuit of this invention.

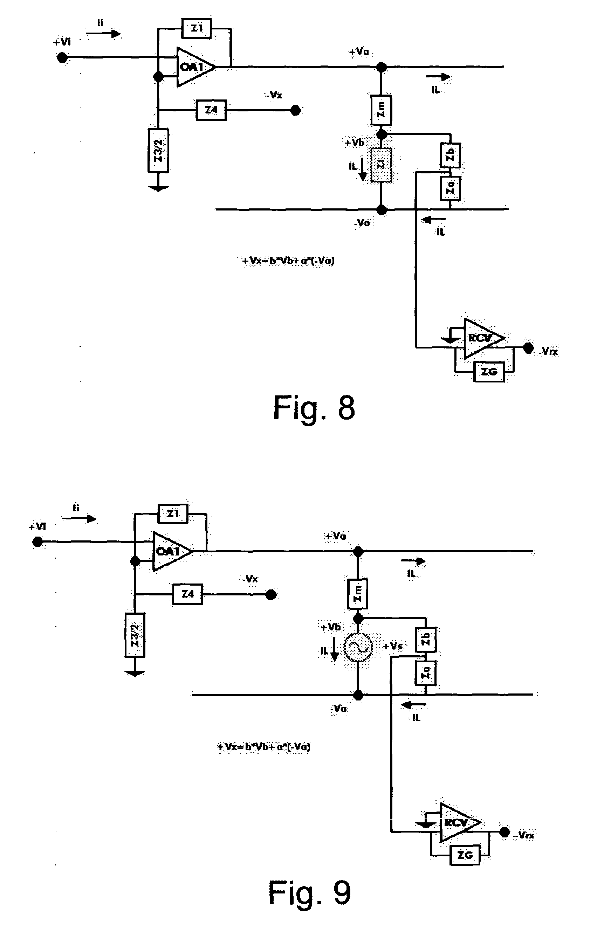

The performance of the circuit will now be described in a mathematical way. Simplified circuits, shown in Figures 8 and 9, will be used to simplify calculation of the various characteristics of the circuit. In the circuit of Figure 7 the internal node +Vx on the secondary winding 261 could be positioned anywhere between the nodes C and B (and similarly node -Vx could be positioned anywhere between the nodes D and A). For the ease of the calculations and to illustrate the benefit of the present invention, we choose here that the internal nodes will be positioned halfway between the external nodes of the primary windings. However, the invention is not limited to this position.

Figure 8 and figure 9 show simplified versions of the circuit of Figure 7. They are simplified in that they show only one amplifier OA1 and one pair of legs of the bridge circuit 260. In figure 8, the winding 261 has been replaced by the equivalent impedance ZL representing the load of the circuit. In figure 9, the winding 261 has been replaced by a voltage source that represents that represents the receive signals coming from the line. It is assumed that ZL, Zm << << Za, Zb, ZG, Z3, Z1, Z4. The circuits of figures 8 and 9 are used to evaluate respectively the transmission and reception characteristics of the circuit of figure 7.

**Impedance synthesis**

Let's call:

$$Vout = Vb - (-Va) \qquad \textbf{Eq 1}$$

If one defines:

$$Vout = TXgain \bullet Vi - Zout \bullet IL \qquad \textbf{Eq 2}$$

One gets:

$$Zout = \frac{Zm \bullet (Z1 + Z4)}{Z4} \qquad \textbf{Eq 3}$$

The Impedance Synthesis Ratio (ISR) is defined as the ratio between Zm and the output impedance of the bridge:

$$Zout = ISR \bullet Zm \qquad \textbf{Eq 4}$$

Using Eq 4 and Eq 3, we get the definition:

$$ISR = \frac{Z1 + Z4}{Z4} \qquad \textbf{Eq 5}$$

Inserting Eq 5 in Eq 2, gives:

$$Vout = TXgain \bullet Vi - ISR \bullet Zm \bullet IL \qquad \textbf{Eq 6}$$

An advantage of the present invention is that the accuracy of the Impedance Synthesis Ratio (ISR) is proportional to the accuracy of the implementation of Z1 and Z4. High ISR values can then easily be implemented.

**Load matching**

In order to achieve good performances from the system point of view the output impedance of the bridge should match the impedance of the line it drives. This gives a constraint on the ISR for a given Zm. It is assumed that:

$$ISR = \frac{ZL}{Zm} \qquad \textbf{Eq 7}$$

Dynamic gain

The gain from the input Vi to the output Vout can be tuned by Z3, Z 1 and Z4. The ratio between Vout and Va is the ratio between the maximum dynamic at the output of the amplifier and its capability to induce a dynamic on the load. In other words, the higher this ratio, the higher the voltage on the load for a given amplifier supply voltage. One defines:

$$Dynamic\_Gain = Dgain = \frac{Vout}{2 \bullet Va} \qquad \text{Eq 8}$$

Using the assumption of Eq 7 and Figure 8, one easily gets:

$$Dgain = \frac{ISR}{1 + ISR} \qquad \text{Eq 9}$$

**Receive gain and directivity**

The directivity of the bridge (hybrid) circuit characterizes the amount of transmit signal that is captured in the receive path. The directivity should be as high as possible so that the amount of 'parasitic' transmitted signal appearing in the receive path is minimal and the maximum dynamic of the receive path is used for the useful signal. When the directivity is infinite, one says that there is perfect echo cancellation.
The directivity of the hybrid depends on the ratio of Impedances Za and Zb. Using the assumption of Eq 7, one can calculate the ratio of Za and Zb that would give a perfect echo cancellation. For the circuit of Figure 8, one gets:

$$\frac{Za}{Zb} = \frac{ISR + 1}{ISR - 1} \qquad \text{Eq 10}$$

using the condition Vrx = 0 for all values of Vi.
From the condition of Eq 10 and using the circuit of Figure 9, one then gets:

$$RXgain = \frac{2 \bullet ZG}{Zb \bullet (1 + ISR)} \qquad \text{Eq 11}$$

One could choose whatever value for ZG and Zb so as to adjust the global receive gain (RXgain) of the receive path. We will normalize ZG to the value of Za in parallel with Zb. This is than the gain that would be obtained if the RX path would be terminated by an inverting follower amplifier.

$$ZG = \frac{1}{\frac{1}{Za} + \frac{1}{Zb}} \qquad \text{Eq 12}$$

$$RXgain = \frac{1}{ISR} \qquad \text{Eq 13}$$

**Complete circuits**

Referring to Figure 7, the overall expressions for the line driver circuit in accordance with the invention are:

$$RXgain\_global = \frac{2 \bullet Vrx}{vout} = \frac{2 \bullet Vrx}{2 \bullet n \bullet Vs} = \frac{1}{n} \bullet \frac{1}{ISR} \qquad \textbf{Eq 14}$$

$$Dgain\_global = \frac{Vload}{2 \bullet Va} = \frac{2 \bullet n \bullet (Vb + Va)}{2 \bullet Va} = 2 \bullet n \bullet \frac{ISR}{1 + ISR} \qquad \textbf{Eq 15}$$

$$ISR = \frac{Z1 + Z4}{Z4} \qquad \textbf{Eq 16}$$

where n is the turns ratio of the transformer.

Before similar expressions are provided for the prior art circuit shown in Figures 1 to 3, the disadvantages of the prior art devices compared with those of the invention is discussed from a physical point of view.

The impedance synthesis functionality relies on the fact that the current flowing through the impedance synthesis related feedback loop flows also through the gain related feedback loop. With a known circuit shown in Figure 1, the feedback loop for impedance synthesis connects to a node of which the voltage swing increases when the impedance synthesis ratio increases. When the impedance synthesis ratio becomes high, the voltage swing of Va and Vb are almost equal in amplitude and phase. The measurement of the current through the load is proportional to the relative difference of voltage between Va and Vb , or proportional to the relative difference of impedance of the two feedback loops (gain related and impedance synthesis related). This difference of two values almost equal to each other is inaccurate. This explains the disadvantage of this circuit compared to those of the present invention.

Regarding the dynamic gain, all comments done about the circuit of the invention remain valid.

The overall expressions for the circuit of Figures 1-3, which correspond to the equations Eq.14 to Eq. 16 are:

$$RXgain\_global = \frac{2 \bullet Vrx}{vout} = \frac{2 \bullet Vrx}{2 \bullet n \bullet Vs} = \frac{1}{n} \bullet \frac{1}{ISR}$$

$$Dgain\_global = \frac{Vout}{2 \bullet Va} = \frac{2 \bullet n \bullet (Vb + Va)}{2 \bullet Va} = 2 \bullet n \bullet \frac{ISR}{1 + ISR}$$

$$ISR = \frac{Zs + Z1}{Zs - Z1}$$

Let's follow the same approach for the circuit of the prior art shown in figures 4 to 6.

The impedance synthesis functionality relies on the fact that the current flowing through the impedance synthesis related feedback loop flows also through the gain related feedback loop. In this circuit as with the circuit of the invention, the feedback loop for impedance synthesis connects to a node of which the voltage swing decreases when the impedance synthesis ratio increases. As a result, the remarks about the accuracy of high impedance synthesis ratios valid for the present invention are also valid for this latter circuit The secondary windings of the transformer are connected in series with a passive impedance between one output of the differential amplifier and the ground (or virtual ground). It's obvious that this reduces by a factor two the dynamic gain compared to a situation where the secondary windings are in series with a passive load between both outputs of the differential amplifier. This explains the disadvantage of this circuit compared to the invention.

The overall expressions for the circuit of Figures 4-6, which correspond to the equations Eq. 14 to Eq. 16 are:

$$RXgain\_global = \frac{2 \bullet Vrx}{vout} = \frac{2 \bullet Vrx}{2 \bullet n \bullet Vs} = \frac{1}{n} \bullet \frac{2}{2 + ISR}$$

$$Dgain\_global = \frac{Vout}{2 \bullet Va} = \frac{2 \bullet n \bullet (Vb + Va)}{2 \bullet Va} = n \bullet \frac{ISR}{1 + ISR}$$

$$ISR = \frac{Z1 + Z4}{Z4}$$

It can be seen from the equation 16 that the circuit of the present invention and the circuit of Figure 1 have the same dynamic gain, twice higher for a given turns ratio than that of the circuit of figure 4. For a given required dynamic gain, this allows circuits of figure 4 and 7 to use a lower turns ratio, leading to a higher receive gain, whatever the ISR. This allows for a higher noise floor in the receive path. In case the requirement related with the noise floor of the receive path is already met, the higher dynamic gain could be used to reduce the voltage supply of the line driver or to increase the ISR so to reduce the power consumption.

It can be seen from the equation 16 that the ISR of the circuit of the present invention and the circuit of figure 4 have an ISR is not inversely proportional to a difference of resistors as opposed to the circuit of figure 1. As a result, the ISR can be increased, hence the power consumption and the voltage supply decreased, without being limited by the accuracy of the resistors used in the implementation.

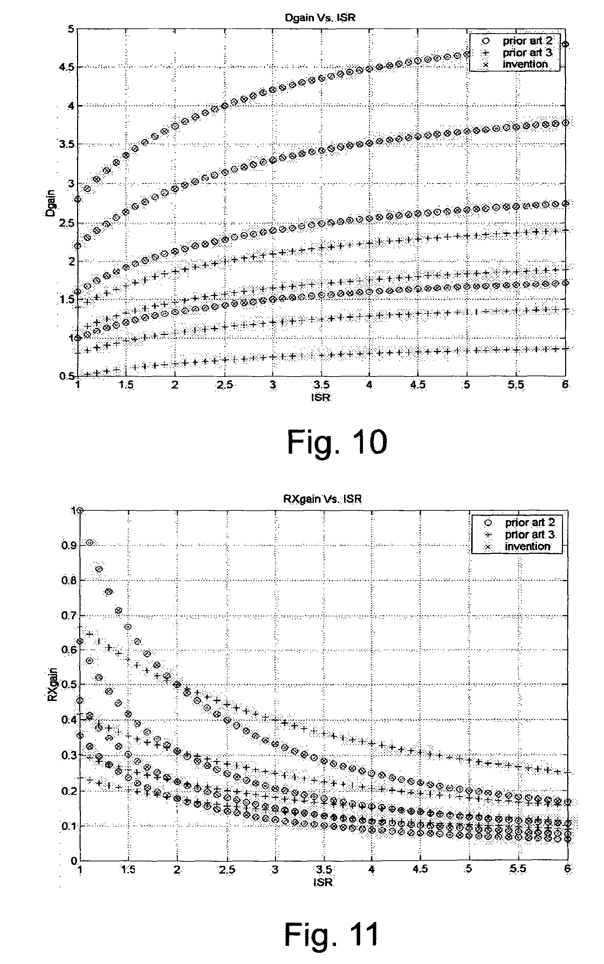

Figures 10 and 11 show the performance of the line drive circuit in comparison to prior art circuits. Figure 10 shows dynamic gain against Impedance Synthesis Ratio (ISR) while Figure 11 shows receive gain against ISR.

The circuit shown in Figure 7 is one possible embodiment of the invention. Some possible variations to the embodiment shown in Figure 7 include:

- An inverting or non-inverting implementation of the line driver.
- Variations of the place of the internal nodes compared to the external nodes of the secondary windings of the isolation transformer, including the addition of supplementary components that allow the access to this internal node.
- The use or the absence of any passive or active device at the output of the receive circuit.
- The implementation of adjustable impedances for Z1, Z3, Z4, Zm, Za or Zb in order to obtain adjustable behaviors of the Impedance synthesis, echo attenuation, transmit gain, power consumption, voltage dynamic or any other characteristic of the circuit.
- Variations of the way the information about the current and/or voltage of the load is used at the input of the line driver.

It is possible to use an inverting or non-inverting topology around the operational amplifiers although the feedback paths for impedance synthesis should be connected to the inverting input of the operational amplifiers, as shown in Figure 7.

The invention is not limited to the embodiments described herein, which may be modified or varied without departing from the scope of the invention.

**Claims**

1.  A line driver circuit (250) for coupling a data transceiver (210, 220) to a line (230) comprising:

      a first amplifier (OA1) having a pair of inputs and an output;
      a second amplifier (OA2) having a pair of inputs and an output, the first and second amplifiers forming a differential amplifier which can receive a signal (+Vi, -Vi) for transmission on the line;
      a first feedback path connected between an output of the first amplifier (OA1) and an inverting input of the first amplifier (OA1);
      a second feedback path connected between an output of the second amplifier (OA2) and an inverting input of the second amplifier (OA2);
      a bridge (260) coupling the first and second amplifiers (OA1, OA2) to the line, the bridge (260) comprising:

a first matching impedance (Zm) and a first secondary transformer winding (262) connected in series between the outputs of the amplifiers;

a second matching impedance (Zm) and a second secondary transformer winding (261) connected in series between the outputs of the amplifiers, the first and second secondary windings (261, 262) being magnetically coupled to at least one primary winding (271, 272) which is connected to the line (230);

a third feedback path connected between an internal node (-Vx) of the first secondary winding (262) and an inverting input of the first amplifier (OA1); and,

a fourth feedback path connected between an internal node (+Vx) of the second secondary winding (261) and an inverting input of the second amplifier (OA2).

2. A line driver circuit according to claim 1 wherein each of the first and second feedback paths include an impedance Z1 and each of the third and fourth feedback paths include an impedance Z4 and wherein the circuit is operable to provide an impedance synthesis ratio (ISR) which is defined by the expression:

$$ISR = \frac{Z1 + Z4}{Z4}.$$

3. A line driver circuit according to any one of the preceding claims further comprising:

a first impedance divider (Za, Zb) which is placed in parallel with the first secondary winding (262) and having an output for connecting to a receive stage (280);

a second impedance divider which is placed in parallel with the second secondary winding (261) and having an output for connecting to the receive stage (280).

4. A line driver circuit according to any one of the preceding claims wherein the dynamic gain of the circuit is defined by the expression:

$$2 \bullet n \bullet \frac{ISR}{1 + ISR}$$

where n is the turns ratio of the secondary and primary windings and *ISR* is the impedance synthesis ratio.

5. A line driver circuit according to any one of the preceding claims wherein branches of the bridge containing the matching impedances (Zm) have an impedance which is significantly smaller than the equivalent impedances of the other branches of the bridge.

6. A line driver circuit according to any one of the preceding claims wherein at least one of the matching impedances (Zm), the impedance divider (Za, Zb) or impedances used in the feedback paths (Z1, Z4) are variable.

7. A line driver according to any one of the preceding claims wherein the first feedback path and the second feedback path are connected between an output and a non-inverting input of a respective amplifier.

8. A line driver according to any one of the preceding claims wherein the first feedback path and the second feedback path are connected between an output and an inverting input of a respective amplifier.

9. A bridge (260) for forming part of a line driver circuit (250) for coupling a data transceiver (210, 220) to a line (230) the bridge comprising:

four legs connected between nodes A, B, C, D;

nodes A and B are connectable to outputs of a differential amplifier (OA1, OA2) in the line driver circuit (250);

a first matching impedance (Zm) connected between nodes A and C and a second matching impedance (Zm) connected between nodes B and D;

a first secondary transformer winding (261) connected between nodes C and B and a second secondary transformer winding (262) connected between nodes A and D, the first and second secondary windings (261, 262) being magnetically coupled to at least one primary winding (271, 272) which is connected to the line (230);
a first tap point connected to an internal node (+Vx) of the first secondary winding (261) a second tap point connected to an internal node (-Vx) of the second secondary winding (262), the first and second tap points forming feedback paths for connecting to the differential amplifier.

10. A bridge according to claim 9 further comprising:

   a first impedance divider (Za, Zb) connected between nodes C and B and having an output for connecting to a receive stage (280);
   a second impedance divider (Za, Zb) connected between nodes D and A and having an output for connecting to the receive stage (280).

11. A modem comprising a line driver circuit (250) or a bridge (260) according to any one of the preceding claims.

12. A portable or stationary device incorporating a line driver circuit according to any one of claims 1 to 9, a bridge according to claim 10 or a modem according to claim 11.

13. A communications system incorporating the apparatus according to any one of the preceding claims.

14. A method of operating a line driver circuit which couples a data transceiver (210, 220) to a line (230) comprising:

   applying a signal (+Vi, -Vi) for transmission on the line to inputs of a first amplifier (OA1) and a second amplifier (OA2);
   providing a first feedback path between an output of the first amplifier (OA1) and an input of the first amplifier (OA1);
   providing a second feedback path between an output of the second amplifier (OA2) and an input of the second amplifier (OA2);
   coupling the first and second amplifiers (OA1, OA2) to the line by a bridge (260) which comprises a first matching impedance (Zm) and a first secondary transformer winding (62) connected in series between the outputs of the amplifiers and a second matching impedance (Zm) and a second secondary transformer winding (261) connected in series between the outputs of the amplifiers, the first and second secondary windings (261, 262) being magnetically coupled to at least one primary winding (271, 272) which is connected to the line (230);
   providing a third feedback path between an internal node (-Vx) of the first secondary winding (262) and an inverting input of the first amplifier (OA1); and,
   providing a fourth feedback path connected between an internal node (+Vx) of the second secondary winding (261) and an inverting input of the second amplifier (OA2).

15. A method according to claim 14 further comprising providing a first impedance divider (Za, Zb) in parallel with the first secondary winding (262) and a second impedance divider which is placed in parallel with the second secondary winding (261) and taking an output, for applying to a receive stage, from the first and second impedance dividers.

16. A method of producing a signal for transmission on a line using the method of claim 14.

17. A method of receiving a signal from a line using the method of claim 15.

18. A method of offering a communication service over a link including a line driver circuit according to any one of claims 1 to 9. a bridge according to claim 10 or a modem according to claim 11.

Fig. 1

Fig. 2

Fig. 3

Fig. 4

Fig. 5

Fig. 6

Fig. 7

Fig. 8

Fig. 9

Fig. 10

Fig. 11

**European Patent Office**

**EUROPEAN SEARCH REPORT**

Application Number

EP 04 07 7552

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | EP 1 241 799 A (ALCATEL) 18 September 2002 (2002-09-18) * abstract * * paragraph [0035] - paragraph [0041] * * paragraph [0049] - paragraph [0051] * * figure 1 * ----- | 1-18 | H04L27/00 H04B1/58 |
| A | US 6 163 579 A (HARRINGTON ET AL) 19 December 2000 (2000-12-19) * abstract * * column 4, line 54 - column 6, line 30 * * figures 4-7 * ----- | 1-18 | |
| A | US 6 323 686 B1 (BISSON ROBERT ET AL) 27 November 2001 (2001-11-27) * column 4, line 39 - line 61 * * figure 4 * ----- | 1-18 | |

TECHNICAL FIELDS
SEARCHED (Int.Cl.7)

H04L
H04B

The present search report has been drawn up for all claims

| Place of search | Date of completion of the search | Examiner |
|---|---|---|
| The Hague | 18 February 2005 | Marselli, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 04 07 7552

This annex lists the patent family members relating to the patent documents cited in the above-mentioned European search report.
The members are as contained in the European Patent Office EDP file on
The European Patent Office is in no way liable for these particulars which are merely given for the purpose of information.

18-02-2005

| Patent document cited in search report | | Publication date | Patent family member(s) | | Publication date |
|---|---|---|---|---|---|
| EP 1241799 | A | 18-09-2002 | EP | 1241799 A1 | 18-09-2002 |
| | | | CN | 1384612 A | 11-12-2002 |
| | | | JP | 2002290285 A | 04-10-2002 |
| | | | US | 2002176569 A1 | 28-11-2002 |
| | | | US | 2004218753 A1 | 04-11-2004 |
| US 6163579 | A | 19-12-2000 | AU | 2793299 A | 20-09-1999 |
| | | | EP | 0980602 A1 | 23-02-2000 |
| | | | WO | 9945655 A1 | 10-09-1999 |
| US 6323686 | B1 | 27-11-2001 | CA | 2279477 A1 | 30-01-2001 |
| | | | AU | 6371800 A | 19-02-2001 |
| | | | CA | 2380321 A1 | 08-02-2001 |
| | | | EP | 1198897 A1 | 24-04-2002 |
| | | | JP | 2003506915 T | 18-02-2003 |
| | | | WO | 0110053 A1 | 08-02-2001 |

EPO FORM P0459

For more details about this annex : see Official Journal of the European Patent Office, No. 12/82